(19) Europäisches Patentamt / European Patent Office / Office européen des brevets

(11) **EP 1 634 373 B1**

(12) **FASCICULE DE BREVET EUROPEEN**

(45) Date de publication et mention de la délivrance du brevet:
**21.03.2007   Bulletin 2007/12**

(21) Numéro de dépôt: **04732266.4**

(22) Date de dépôt: **12.05.2004**

(51) Int Cl.:
*H03L 1/02* (2006.01)     *G04G 3/02* (2006.01)
*G04F 5/04* (2006.01)     *G01K 7/32* (2006.01)

(86) Numéro de dépôt international:
**PCT/CH2004/000288**

(87) Numéro de publication internationale:
**WO 2004/102809 (25.11.2004 Gazette 2004/48)**

(54) **ARCHITECTURE POUR BASE DE TEMPS**

ZEITBASISARCHITEKTUR

LAYOUT FOR A TIME BASE

(84) Etats contractants désignés:
**AT BE BG CH CY CZ DE DK EE ES FI FR GB GR HU IE IT LI LU MC NL PL PT RO SE SI SK TR**

(30) Priorité: **15.05.2003   FR 0305834**

(43) Date de publication de la demande:
**15.03.2006   Bulletin 2006/11**

(73) Titulaire: **CSEM Centre Suisse d'Electronique et de Microtechnique SA**
**2007 Neuchâtel (CH)**

(72) Inventeur: **RUFFIEUX, David**
**CH-1728 Belfaux (CH)**

(74) Mandataire: **GLN**
**Rue du Puits-Godet 8a**
**2000 Neuchâtel (CH)**

(56) Documents cités:
**US-A- 3 826 931**

- **BLOCH M ET AL: "Low power timekeeping" 43RD ANNUAL SYMPOSIUM ON FREQUENCY CONTROL - 1989, 31 mai 1989 (1989-05-31), pages 34-36, XP010084239**
- **BLOCH M ET AL: "The microcomputer compensated crystal oscillator (MCXO)" 43RD ANNUAL SYMPOSIUM ON FREQUENCY CONTROL - 1989, 31 mai 1989 (1989-05-31), pages 16-19, XP010084236**
- **PATENT ABSTRACTS OF JAPAN vol. 004, no. 165 (E-034), 15 novembre 1980 (1980-11-15) & JP 55 112043 A (SEIKO INSTR & ELECTRONICS LTD), 29 août 1980 (1980-08-29)**
- **LANFRANCHI D ET AL: "A MICROPROCESSOR-BASED ANALOG WRISTWATCH CHIP WITH 3 SECONDS/YEAR ACCURACY" IEEE INTERNATIONAL SOLID STATE CIRCUITS CONFERENCE, IEEE INC. NEW YORK, US, vol. 37, 1 février 1994 (1994-02-01), pages 92-93,317, XP000507075 ISSN: 0193-6530 cité dans la demande**

EP 1 634 373 B1

**Description**

L'invention concerne une architecture, notamment pour base de temps d'une pièce d'horlogerie, destinée à générer une référence de temps ainsi qu'un procédé de génération d'une référence de temps.

Dans le domaine de l'horlogerie se pose le problème de la précision des bases de temps présentes dans les pièces d'horlogerie et, plus particulièrement pour les chronomètres, celui de la correction du signal émis par un résonateur afin de compenser la dérive en fréquence, due à la température, de ce signal.

La plupart des bases de temps connues comportent un résonateur à 32kHz de type diapason dont la coupe est choisie de manière à annuler le coefficient thermique de premier ordre de la caractéristique thermique. On obtient ainsi un garde-temps avec une caractéristique thermique quadratique menant à une dérive de -20ppb/°C$^2$. Toutefois, cette dérive est encore trop importante et ne permet pas d'obtenir une précision de la base de temps telle qu'une pièce d'horlogerie qui en est équipée puisse obtenir la mention de chronomètre, par exemple, selon les normes du Contrôle Officiel Suisse des Chronomètres (COSC).

Différentes solutions, pour réduire l'effet d'une telle dérive, ont été imaginées par les horlogers. Une première solution consiste à réaliser une compensation électronique par réglage d'inhibition faisant suite à une mesure de la température. Cette solution nécessite, toutefois, de disposer d'une mesure de température adéquate et de mettre en oeuvre une étape de calibration initiale. Une autre solution est décrite dans le document intitulé « A microprocessor-based analog wristwatch chip with 3-seconds/year accuracy » par D. Lanfranchi, E. Dijkstra et D. Aebischer, CSEM Centre Suisse d'Electronique et de Microtechnique, ISSCC 1994. Ce document décrit une solution supposant l'utilisation d'un résonateur à quartz de coupe ZT avec des coefficients thermiques de premier et deuxième ordre nuls. Dans ce cas, un résonateur travaillant à fréquence élevée, de l'ordre de 2MHz, est utilisé comme référence de temps pour déterminer s'il y a dérive en fréquence d'un autre résonateur à quartz, moins précis et dont la fréquence est de l'ordre de 32kHz. Cette solution, toutefois, implique l'ajout d'un résonateur à quartz ZT à fréquence élevée, ce qui entraîne une forte consommation de l'ensemble. Pour remédier à ce problème de consommation importante, le quartz ZT est utilisé en combinaison avec un quartz à 32kHz moins précis mais permettant, par une mise en veille régulière de l'oscillateur utilisant le quartz ZT, d'atteindre une consommation moyenne très basse. En fonction de l'inertie thermique de la pièce d'horlogerie, on rallume périodiquement, et pour un bref instant, la référence de temps plus précise pour synchroniser à nouveau les deux bases de temps. Toutefois, cette solution nécessite de disposer d'un résonateur de grande précision avec une fréquence très stable en température. D'autre part, l'ajout d'un résonateur à quartz de type ZT entraîne un surcoût de fabrication et un encombrement indésirables.

Le document intitulé "Résonateurs intégrés et base de temps incorporant de tels résonateurs" et faisant l'objet d'une demande de brevet français déposée par la demanderesse le même jour que la présente demande, décrit une base de temps comprenant deux résonateurs intégrés dans un substrat de silicium, exploitant des modes de résonance différents et oscillant à des fréquences différentes. Ces résonateurs présentent, chacun, une dérive en fréquence due à la température très importante. On constate que, dans les conditions de réalisation de ces résonateurs telles que décrites, la différence entre les signaux émis par les deux résonateurs permet d'obtenir une référence de temps très précise, dont la dérive thermique est très faible. L'annulation du coefficient thermique de premier ordre est obtenue par différence entre les fréquences de ces deux résonateurs. La réduction du coefficient thermique du deuxième ordre est effectuée par une orientation appropriée des deux résonateurs dans leur substrat. Il est alors possible, sur la base de tels résonateurs, de construire une base de temps stable en température et suffisamment précise pour envisager son application à des chronomètres. Toutefois, comme indiqué dans la demande précitée, les fréquences de tels résonateurs sont élevées, ce qui conduit là encore à une consommation de la base de temps trop importante pour des applications portables, telles les montres-bracelets.

L'objet de l'invention est donc de remédier aux inconvénients cités précédemment et notamment de fournir une architecture à base de résonateurs, dont la fréquence n'est pas forcément stable en température, comme les résonateurs en silicium, et permettant d'obtenir une base de temps précise et à faible consommation et ce, indépendamment des conditions thermiques environnantes.

L'invention a donc pour objet une architecture, notamment pour base de temps, dont le signal de sortie est destiné à constituer une référence de temps, comprenant

- un premier oscillateur de fréquence $F_1$ et de fréquence propre $F_{10}$,
- un circuit oscillateur comprenant un deuxième oscillateur de fréquence $F_2$ différente de celle du premier oscillateur, de fréquence propre $F_{20}$ et, qui présente un coefficient thermique de premier ordre dans un rapport $\lambda.F_{10}/F_{20}$ avec le coefficient thermique de premier ordre du premier oscillateur, $\lambda$ étant un facteur de proportionnalité,
- des moyens pour générer, par différence de fréquence entre le signal émis par le premier oscillateur et le signal émis par le circuit oscillateur, une première référence de temps stable en température.

Le brevet US 3,826,931 décrit une architecture similaire, dans laquelle des signaux de fréquences respectives différentes, délivrés par des résonateurs différents, sont combinés pour produire un signal dont la fréquence est sensiblement stable en température.

Toutefois, l'architecture selon la présente invention est en outre caractérisée par le fait

- que les résonateurs respectifs des premier et deuxième oscillateurs sont réalisés en silicium,
- que le circuit oscillateur comprend également un diviseur de fréquence divisant la fréquence $F_2$ du signal émis par le deuxième oscillateur par le facteur $\lambda$ et générant le signal de sortie de ce circuit oscillateur,
- qu'elle comporte des moyens pour déterminer la dérive en fréquence, due à la température, du signal émis par le premier oscillateur par comparaison du signal émis par le premier oscillateur avec la première référence de temps stable en température, et
- qu'elle comporte des moyens de correction programmables qui, en fonction de la valeur de ladite dérive, divisent la fréquence du signal émis par le premier oscillateur et génèrent ledit signal de sortie formant une deuxième référence de temps stable en température.

L'architecture selon l'invention peut en outre comporter les caractéristiques suivantes :

- l'architecture comprend des moyens pour compter, pendant une phase de comptage et pendant un nombre de cycles prédéterminé de la première référence de temps, le nombre d'impulsions générées par le premier oscillateur, et
- l'architecture comprend des moyens pour déterminer ladite dérive en fréquence et commander lesdits moyens de correction programmables, en fonction dudit nombre d'impulsions décompté et dudit nombre de cydes de la première référence de temps pendant lequel on a autorisé le comptage.
- l'architecture comprend des moyens de mise en veille pour mettre en veille par intermittence le deuxième oscillateur et en ce que ladite phase de comptage se déroule pendant une phase d'activité du deuxième oscillateur.
- lesdits moyens de mise en veille comporte des moyens permettant de faire varier l'intervalle de temps entre deux réveils successifs, en fonction de la précision souhaitée pour la deuxième référence de temps et/ou du nombre d'impulsions décompté pour le premier oscillateur lors de l'une au moins des phases de comptage précédentes.
- l'architecture comprend des moyens pour générer une information de température à partir du nombre d'impulsions générées par le premier oscillateur lors de la phase de comptage.
- l'architecture comprend des moyens pour mémoriser des informations de calibration de la première référence de temps stable en température.
- les moyens de correction comportent un diviseur de fréquence programmable possédant une gamme de taux de division permettant de compenser les dérives en fréquence du premier oscillateur dues à la température et/ou la précision absolue du premier oscillateur.

L'invention a également pour objet un procédé de génération d'un signal destiné à constituer une référence de temps comportant les étapes suivantes :

- génération d'une première fréquence par un premier oscillateur comportant un résonateur en silicium, de fréquence propre $F_{10}$,
- génération d'une deuxième fréquence, différente de la première fréquence, par un deuxième oscillateur comportant un résonateur en silicium, de fréquence propre $F_{20}$, le coefficient thermique de premier ordre du premier oscillateur étant sensiblement égal au coefficient thermique de premier ordre du deuxième oscillateur multiplié par le rapport $F_{20}/\lambda\,F_{10}$, $\lambda$ étant un facteur de proportionnalité,
- génération d'une première référence de temps stable en température par différence de fréquence entre le signal émis par le premier oscillateur et le signal émis par le deuxième oscillateur, après division de ce dernier par le facteur $\lambda$,
- détermination par comparaison du signal émis par le premier oscillateur avec la première référence de temps de la dérive en fréquence due à la température du signal émis par le premier oscillateur,
- correction, en fonction de la valeur de ladite dérive, de la fréquence du signal émis par le premier oscillateur pour générer ledit signal de sortie formant une deuxième référence de temps.

L'invention tire profit de ces caractéristiques afin de générer, de façon simple, à partir de résonateurs en silicium, une référence de temps suffisamment précise pour pouvoir répondre aux exigences du COSC. En particulier, l'invention ne nécessite pas l'utilisation de résonateurs de grande précision, ni très stables en température tels que les résonateurs à quartz ZT, qui peuvent être coûteux ou augmenter l'encombrement et la complexité de fabrication de la base de temps. En outre, une réalisation à base de résonateurs en silicium permet d'envisager l'utilisation du dispositif selon l'invention dans des applications variées, notamment celles utilisant déjà des circuits intégrés à base de silicium comme, par exemple, les ordinateurs de poche, assistants personnels ou autres dispositifs électroniques de dimensions réduites.

D'autres caractéristiques et avantages de la présente invention apparaîtront au cours de la description qui va suivre, donnée uniquement à titre d'exemple, et faite en se référant aux figures annexées sur lesquelles :

- la figure 1 est un schéma de principe d'une base de temps telle que décrite dans la demande parallèle précitée;
- la figure 2 est un schéma de principe d'une base de temps selon l'invention,
- la figure 3 est un organigramme décrivant le fonctionnement du bloc de commande CTRL compris dans l'architecture suivant l'invention.

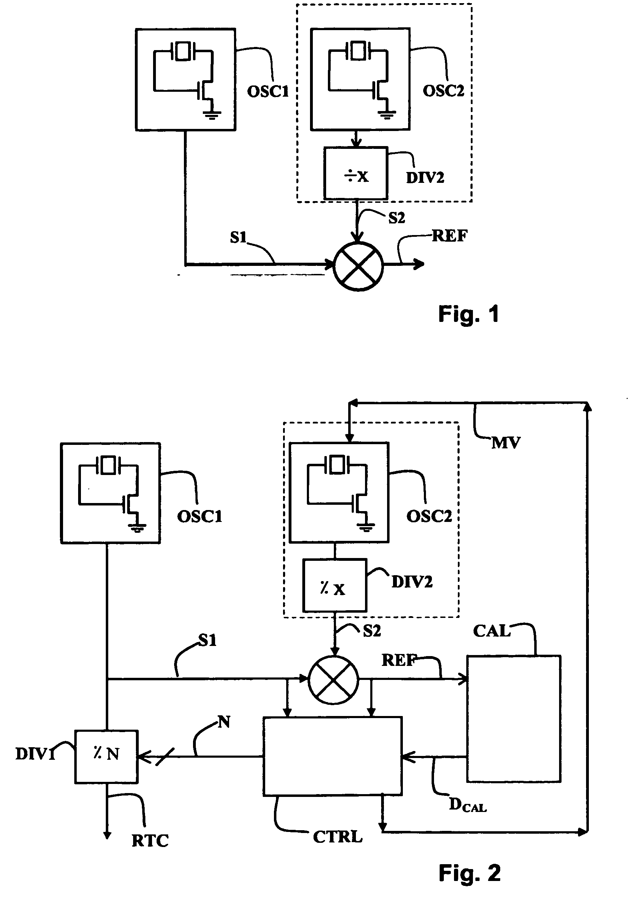

La figure 1 représente un schéma de principe d'une base de temps utilisant la différence de fréquence des signaux issus de deux oscillateurs comprenant chacun un résonateur en silicium. Sur cette figure, le premier oscillateur OSC1 fonctionne à une fréquence plus basse que l'oscillateur OSC2. En sortie du deuxième oscillateur se trouve un diviseur de fréquence DIV2, associé au deuxième oscillateur OSC2 et réalisant une division de fréquence par un nombre entier $\lambda$, ces deux composants définissant, ensemble, un circuit oscillateur (symbolisé par des traits discontinus sur les figures 1 et 2). La différence de fréquence entre le signal S1 issu du premier oscillateur OSC1 et le signal S2 issu du deuxième oscillateur OSC2, après division de la fréquence par un facteur $\lambda$, constitue une référence de temps REF dont la fréquence est stable, si le rapport entre les fréquences est l'inverse du rapport de leur coefficient thermique du premier ordre.

Comme décrit dans la demande parallèle précitée, si les deux oscillateurs OSC1, OSC2 sont choisis de manière à satisfaire la condition précédente, on obtient une annulation du coefficient thermique de premier ordre pour la référence de temps REF et donc, une différence de fréquence stable bien que chacun des deux oscillateurs présente une importante dérive thermique.

En effet, si la fréquence $F_1$ du premier oscillateur OSC1 est, en première approximation, telle que :

$$F_1( \Delta T ) = F_{10} * ( 1 + \alpha_1 * \Delta T)$$

$\Delta T$ étant une variation de température, $\alpha_1$ le coefficient thermique de premier ordre de l'oscillateur OSC1 et $F_{10}$ sa fréquence propre,
et si la fréquence $F_2$ du deuxième oscillateur OSC2 est, en première approximation, telle que :

$$F_2( \Delta T ) = F_{20} * ( 1 + \alpha_2 * \Delta T)$$

$\alpha_2$ étant le coefficient thermique de premier ordre de l'oscillateur OSC2 et $F_{20}$ sa fréquence propre et qu'en outre, la condition suivante est satisfaite :

$$\lambda * \alpha_1 * F_{10} = \alpha_2 * F_{20}$$

alors, après division de la fréquence du deuxième oscillateur OSC2 par un facteur $\lambda$, on obtient une fréquence $F'_2$ telle que:

$$F'_2( \Delta T ) = F_2( \Delta T ) / \lambda = ( F_{20} / \lambda ) * ( 1 + \alpha_2 * \Delta T) = (F_{10} * \alpha_1 / \alpha_2)(1 + \alpha_2 * \Delta T).$$

En outre, par différence entre $F'_2$ et $F_1$ on obtient une fréquence $F_R$ telle que

$$F_R( \Delta T ) = F'_2( \Delta T ) - F_1( \Delta T ) = F_{10} * (\alpha 1 - \alpha 2) / \alpha 2$$

c'est-à-dire, en négligeant les coefficients thermiques d'ordres supérieurs, une fréquence indépendante de la température, qui est celle de la référence de temps REF. Comme indiqué précédemment, la demande précitée prévoit également des moyens pour annuler, ou réduire fortement, le coefficient thermique de deuxième ordre de la différence de fréquence $F_R$.

La figure 2 représente schématiquement une architecture, notamment pour base de temps, utilisant le principe qui vient d'être évoqué. L'architecture comprend un premier oscillateur OSC1 qui fonctionne à une fréquence plus basse qu'un deuxième oscillateur OSC2. Des moyens de correction programmables agissent sur la sortie du premier oscillateur OSC1, effectuant une division programmable de la fréquence du signal S1 émis par le premier oscillateur OSC1 et générant ainsi la référence de temps RTC de sortie de la base de temps. Les moyens de correction programmables sont réalisés, selon l'exemple de la figure 2, par un diviseur programmable effectuant une division de fréquence par un facteur N sur le signal S1 émis par le premier oscillateur.

Un deuxième diviseur DIV2, agit sur la sortie du deuxième oscillateur OSC2, effectuant une division de fréquence par un nombre entier $\lambda$ et générant un signal S2 dont la différence avec la sortie S1 du premier oscillateur OSC1 forme une première référence de temps REF. Comme expliqué précédemment, on choisit les oscillateurs de manière à ce qu'au moins le coefficient thermique de premier ordre du signal REF soit nul. De cette façon, la fréquence de la première référence de temps REF est stable en température.

La base de temps selon l'invention comporte, en outre, un bloc de calibration CAL utilisé lors d'une phase initiale de calibration et qui, en fonctionnement normal hors de cette phase de calibration, sert de moyen de stockage des données issues de la calibration.

Ce bloc de calibration CAL est relié à un bloc de commande CTRL dont le rôle est de commander le diviseur programmable DIV1 relié au premier oscillateur OSC1 à faible consommation. Ce bloc de commande utilise dans ce but le signal S1 généré par le premier oscillateur OSC1, le signal de la référence stable REF et les données $D_{CAL}$ stockées dans le bloc de calibration et issues de la phase de calibration. D'autre part, ce bloc de commande CTRL génère des signaux MV de commande permettant de mettre en veille ou, au contraire, de réveiller l'oscillateur OSC2, l'oscillateur OSC1 fonctionnant, quant à lui, en permanence.

Le principe de fonctionnement de cette architecture et les différentes variantes de réalisation sont donnés plus en détail ci-dessous.

Le bloc de calibration CAL contient en mémoire une valeur de la fréquence de la référence stable REF. Cette valeur est obtenue lors d'une phase de calibration initiale pendant laquelle on compare cette référence stable avec une référence extérieure très précise. Pour cela, on peut par exemple mesurer le temps nécessaire par rapport à cette référence extérieure pour compter un nombre d'impulsions donné de la référence stable REF, nombre égal à $10^6$, par exemple, pour obtenir une précision du ppm ($10^{-6}$). La valeur de la fréquence de la référence stable REF est alors obtenue en faisant le rapport entre le nombre d'impulsions compté et la durée de calibration mesurée au moyen de la référence extérieure. Ainsi, si la durée de calibration est de 1,872s, la fréquence de la référence stable sera de $10^6/$1,872 = 0,534 MHz. En fonction de la précision souhaitée sur la mesure, le nombre d'impulsions pourra être plus élevé, mais le temps de calibration en sera proportionnellement plus grand.

La valeur de la fréquence de la référence stable REF obtenue par calibration est mémorisée dans le bloc de calibration CAL, par exemple avec une précision de l'ordre du ppm. La calibration initiale peut se faire à température ambiante sans nuire à la précision de la mesure car la dérive en température de la référence stable REF est très faible. La valeur de cette fréquence de référence est stockée de manière non volatile dans le bloc de calibration CAL, de façon à être disponible lors du fonctionnement normal hors calibration de la base de temps.

Le bloc de commande CTRL utilise cette information de calibration pour générer à partir du signal S1 de sortie du premier oscillateur OSC1 et du signal de référence stable REF, un signal de commande commandant lesdits moyens de correction. Dans l'exemple de la figure 2, ce signal de commande permet d'ajuster le facteur de division N du premier diviseur programmable DIV1 agissant sur la sortie du premier oscillateur OSC1.

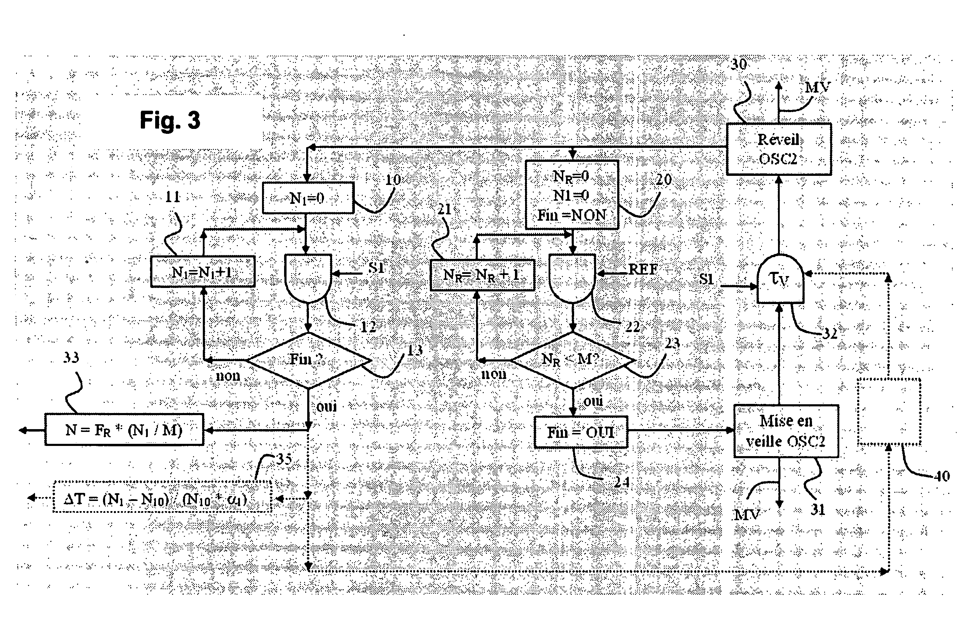

La détermination de ce signal de commande est décrite par l'organigramme de la figure 3. Sur cet organigramme se déroule une phase de comptage pendant laquelle a lieu, en parallèle, un comptage des impulsions du signal S1 émis par le premier oscillateur OSC1 et un comptage des impulsions de la référence stable REF.

Le processus de détermination commence lorsque, à l'étape 30, on réveille le deuxième oscillateur OSC2 au moyen d'un signal MV de réveil généré par le bloc de commande CTRL. La référence stable REF est alors disponible pour les phases suivantes. Suit une étape de réinitialisation 20 pendant laquelle on remet à zéro la valeur du compteur $N_R$ comptant les impulsions de la référence stable REF, on met à la valeur NON un drapeau Fin indicateur de la fin de la phase de comptage et on remet à zéro la valeur du compteur $N_1$ comptant les impulsions du signal S1 émis par le premier oscillateur OSC1.

La valeur du compteur $N_R$ est incrémentée à l'étape 21 lorsque, après un temps de latence (étape 22) correspondant à la période de la référence stable REF, on constate après comparaison à l'étape 23 que la valeur du compteur $N_R$ reste inférieure à une valeur M prédéterminée. La valeur M correspond ainsi au nombre d'impulsions de la référence stable REF définissant la durée de la phase de comptage. Lorsque la valeur du compteur $N_R$ atteint la valeur M, le processus de comptage des impulsions de la référence stable REF s'arrête à l'étape 24 où on met à la valeur OUI le drapeau Fin, ce qui signale la fin de la phase de comptage. Lorsque la phase de comptage se termine à l'étape 24, on remet en veille à l'étape 31 le deuxième oscillateur OSC2 en générant un signal MV de mise en veille du deuxième oscillateur OSC2.

Pendant que se déroulent les étapes 21, 22 et 23 qui viennent d'être décrites, la valeur du compteur $N_1$ est incrémentée à l'étape 11, lorsque après un temps de latence (étape 12) correspondant à la période du signal S1, on détecte, par examen de la valeur du drapeau Fin, que la phase de comptage n'est pas terminée.

Si au contraire le drapeau Fin, de par sa valeur, indique que la phase de comptage est terminée, on détermine alors à l'étape 33 la valeur du facteur N de division destiné à programmer le diviseur DIV1 comme étant le nombre $N_1$ d'impulsions de l'oscillateur à faible consommation tel que décompté, multiplié par la valeur de la référence de fréquence obtenue par calibration initiale $F_R$ et divisé par le nombre de cycles M de la référence de fréquence pendant lequel on a autorisé le comptage. On obtient donc en sortie du diviseur programmable un signal de fréquence F'1 telle que :

$$F'_1 = F_1 / N = ( F_1 / N_1 ) * ( M / F_R )$$

c'est-à-dire un signal de fréquence 1 Hz, donnant donc la seconde.

Si maintenant la fréquence instantanée F1 du premier oscillateur OSC1 augmente, c'est-à-dire que le nombre d'impulsions $N_1$ décompté augmente, la valeur du facteur de division N appliqué au diviseur DIV1 sera proportionnellement plus élevée. Après une telle programmation du premier diviseur DIV1 avec ladite valeur, la référence de temps RTC en sortie du dispositif est ainsi réajustée.

Le nombre prédéterminé M d'impulsions pour la référence stable REF est choisi de façon à compter par exemple environ un million d'impulsions sur le premier oscillateur OSC1. Ce nombre d'impulsions doit être ajusté en fonction de la précision souhaitée pour la base de temps. Plus il est élevé et plus la précision obtenue sera grande, mais plus la consommation moyenne du dispositif sera élevée.

De manière à réduire la consommation du dispositif selon l'invention, seul l'oscillateur OSC1 travaillant à la fréquence la plus basse est excité en permanence. Selon un mode de réalisation avantageux, le deuxième oscillateur OSC2 est mis en veille par intermittence. La référence stable REF est donc disponible uniquement dans le mode de fonctionnement où l'oscillateur OSC2 est réveillé.

Ceci permet d'obtenir une réduction sensible de la consommation du dispositif. Avec une fréquence de l'oscillateur à faible consommation proche du MHz et une différence de fréquence de l'ordre de 100kHz, il faut compter dix secondes de calibration initiale pour obtenir la référence de fréquence stable REF, mais une seule seconde pour arriver à un comptage d'un million de cycles de l'oscillateur OSC1 alimenté en permanence. On obtient une base de temps avec la seconde précise au ppm.

Avec le dispositif selon l'invention, c'est l'inertie thermique de l'équipement dans lequel il est monté, par exemple une pièce d'horlogerie, qui va déterminer le taux de réveil de l'oscillateur à haute fréquence. Du fait de la valeur élevée de la dérive thermique d'un résonateur (de l'ordre de 30ppm/°C), le réajustement du facteur de division N doit intervenir au minimum chaque dixième de degré lors d'une variation de température. Avec une inertie de l'ordre de 1 °C/min, il faut donc réveiller l'oscillateur à fréquence plus élevée OSC2 chaque 6s pour une durée de 1s, réduisant ainsi la consommation nécessaire au fonctionnement de l'ensemble d'un facteur 6, par rapport à un dispositif dans lequel les deux oscillateurs fonctionneraient en permanence.

La précision de fabrication du résonateur donne une référence de fréquence absolue précise à $\pm 0.05\%$. Une dérive de 30ppm/°C sur une gamme de température de $\pm 15°C$ produit également une dérive totale du même ordre. Si donc, on utilise un diviseur programmable DIV1 capable de générer un taux de division compris entre 99.9% et 100.1% de la valeur de la fréquence de l'oscillateur OSC1 alimenté en permanence, on peut compenser d'un seul coup la précision absolue et les variations thermiques sans procéder à un quelconque ajustage préalable des résonateurs.

Par ailleurs, du fait qu'on dispose d'une référence de temps REF stable en température et d'un signal issu du premier oscillateur OSC1 présentant une bonne linéarité à la température (si on néglige l'effet du coefficient thermique de deuxième ordre), la valeur de la fréquence du premier oscillateur OSC1 connecté en permanence devient une indication directe de la température des oscillateurs et ce, avec une bonne linéarité, sous forme numérique et avec une précision de l'ordre du $1/30^{ème}$ de °C.

Dans ce cas il est nécessaire de mesurer lors de la phase de calibration la température $T_0$ initiale et de décompter pour cette température le nombre d'impulsions $N_{10}$ du premier oscillateur OSC1 pendant le nombre d'impulsions M prédéterminé. Cette procédure de décomptage est identique à la phase de comptage décrite précédemment, utilisée hors phase de calibration, en mode de fonctionnement normal. Ces valeurs initiales $T_0$ et $N_{10}$ seront stockées dans le bloc de calibration, comme la fréquence de la référence $F_R$, de manière non volatile. En fonctionnement normal, la température sera alors réévaluée, après chaque phase de comptage, à partir du nombre d'impulsions $N_1$ du signal S1 issu du premier oscillateur, en fonction du nombre $N_1$ obtenu et selon la formule :

$$T = T_0 + (N_1 - N_{10}) / (N_{10} * \alpha_1)$$

Avantageusement, le bloc de commande CTRL comprend donc des moyens pour déterminer l'écart de tem-

pérature $\Delta T = T - T_0$ et générer, selon l'étape 35, représentée en trait pointillé sur la figure 3, la valeur de cet écart de température selon la formule :

$$\Delta T = (N_1 - N_{10}) / (N_{10} * \alpha_1).$$

Il résulte de ces considérations une multitude de variantes d'application de l'invention qui vont, soit tirer profit de cette information de température pour elle-même en l'exploitant dans une application de type thermomètre, soit simplement tirer profit de cette information pour réguler au mieux la durée des phases de mise en veille/activité de l'oscillateur OSC2 et donc ainsi permettre de réduire au maximum la consommation du dispositif selon l'invention.

Ainsi selon le diagramme de la figure 3, l'intervalle de temps s'écoulant entre une mise en veille et le réveil suivant est déterminé par un temps de latence (étape 32) d'une valeur $\tau_v$ qui correspond à un nombre d'impulsions du signal S1 issu du premier oscillateur OSC1. Cette valeur pourra être fixe et, dans ce cas, déterminée en fonction de la précision souhaitée sur la référence de temps RTC et de la dérive thermique maximale possible. Cette valeur pourra aussi être déterminée après chaque phase de comptage, par exemple par une méthode de prédiction linéaire sur la dérive en fréquence mesurée par le facteur de correction N ou plus directement, selon l'exemple suggéré sur la figure 3 par l'étape 40, à partir de la valeur $N_1$ tel que décompté suite à l'étape 13.

En conclusion l'invention qui vient d'être décrite peut non seulement être utilisée dans la réalisation de bases de temps mais également dans toute application de type thermomètre nécessitant une grande précision.

## Revendications

1. Architecture, dont le signal de sortie est destiné à constituer une référence de temps, comprenant

   - un premier oscillateur (OSC1), comportant un résonateur, de fréquence $F_1$, de fréquence propre $F_{10}$ et générant un signal de sortie (S1),
   - un circuit oscillateur comprenant un deuxième oscillateur (OSC2), comportant un résonateur, dont la fréquence $F_2$ est différente de celle du premier oscillateur (OSC1) et de fréquence propre $F_{20}$,
   - le deuxième oscillateur (OSC2) présentant un coefficient thermique de premier ordre $\alpha_2$ dans un rapport $\lambda.F_{10}/F_{20}$ avec le coefficient thermique de premier ordre $\alpha_1$ dudit premier oscillateur (OSC1), $\lambda$ étant un facteur de proportionnalité,
   - des moyens pour générer, par différence de fréquence entre le signal (S1) émis par le premier oscillateur (OSC1) et le signal (S2) émis par le circuit oscillateur, une première référence de temps (REF) stable en température,

   **caractérisée**

   - **en ce que** lesdits résonateurs respectifs desdits premier et deuxième oscillateurs sont en silicium,
   - **en ce que** ledit circuit oscillateur comprend en outre un diviseur de fréquence divisant la fréquence $F_2$ du signal émis par ledit deuxième oscillateur (OSC2) par ledit facteur $\lambda$ et générant le signal (S2) de sortie dudit circuit oscillateur,
   - **en ce qu'**elle comprend des moyens (CTRL) pour déterminer la dérive en fréquence due à la température du signal (S1) émis par le premier oscillateur (OSC1) par comparaison du signal (S1) émis par le premier oscillateur (OSC1) avec la première référence de temps (REF) stable en température, et
   - **en ce qu'**elle comprend des moyens de correction (DIV1) programmables qui, en fonction de la valeur de ladite dérive, divisent la fréquence du signal (S1) émis par le premier oscillateur (OSC1) et génèrent ledit signal de sortie formant une deuxième référence de temps (RTC) stable en température.

2. Architecture selon la revendication 1, **caractérisée en ce qu'**elle comprend :

   - des moyens (10, 11, 12, 13) pour compter, pendant une phase de comptage et pendant un nombre de cycles (M) prédéterminé de la première référence de temps (REF), le nombre d'impulsions (N1) générées par le premier oscillateur (OSC1), et
   - des moyens (33) pour déterminer ladite dérive en fréquence et commander lesdits moyens de correction programmables, en fonction dudit nombre d'impulsions (N1) décompté et dudit nombre de cycles (M) de la première référence de temps (REF) pendant lequel on a autorisé le comptage.

**3.** Architecture selon la revendication 2, **caractérisée en ce qu'**elle comprend des moyens de mise en veille (MV) pour mettre en veille par intermittence le deuxième oscillateur (OSC2) et **en ce que** ladite phase de comptage se déroule pendant une phase d'activité du deuxième oscillateur (OSC2).

**4.** Architecture selon la revendication 3, **caractérisée en ce que** lesdits moyens de mise en veille (MV) comportent des moyens permettant de faire varier l'intervalle de temps entre deux réveils successifs, en fonction de la précision souhaitée pour la deuxième référence de temps (RTC) et/ou du nombre d'impulsions ($N_1$) décompté pour le premier oscillateur (OSC1) lors de l'une au moins des phases de comptage précédentes.

**5.** Architecture selon l'une des revendications 1 à 4, **caractérisée en ce qu'**elle comprend des moyens pour générer une information de température à partir du nombre d'impulsions (N1) générées par le premier oscillateur (OSC1) lors de la phase de comptage.

**6.** Architecture selon une des revendications 1 à 5, **caractérisé en ce qu'**elle comprend des moyens pour mémoriser des informations de calibration de la première référence de temps (REF) stable en température.

**7.** Architecture selon une des revendications 1 à 6, **caractérisée en ce que** les moyens de correction comportent un diviseur de fréquence programmable possédant une gamme de taux de division permettant de compenser les dérives en fréquence du premier oscillateur (OSC1) dues à la température et/ou la précision absolue du premier oscillateur (OSC1).

**8.** Base de temps comportant une architecture selon l'une des revendications 1 à 7.

**9.** Thermomètre comportant une architecture selon l'une des revendications 1 à 7.

**10.** Pièce d'horlogerie comportant une architecture selon l'une des revendications 1 à 7.

**11.** Procédé de génération d'un signal destiné à constituer une référence de temps comportant les étapes suivantes :

- génération d'un premier signal (S1) de sortie, d'une première fréquence $F_1$, par un premier oscillateur (OSC1), comportant un résonateur en silicium, de fréquence propre $F_{10}$,
- génération d'une deuxième fréquence $F_2$, différente de la première fréquence, par un deuxième oscillateur (OSC2), comportant un résonateur en silicium, de fréquence propre $F_{20}$ et présentant un coefficient thermique de premier ordre $\alpha_2$ dans un rapport $\lambda.F_{10}/F_{20}$ avec le coefficient thermique de premier ordre $\alpha_1$ dudit premier oscillateur (OSC1), $\lambda$ étant un facteur de proportionnalité,
- division de la fréquence $F_2$ du signal émis par ledit deuxième oscillateur (OSC2), par ledit facteur $\lambda$, pour générer un deuxième signal (S2) de sortie,
- génération d'une première référence de temps (REF) stable en température par différence de fréquence entre ledit premier signal (S1) émis par le premier oscillateur (OSC1) et ledit deuxième signal (S2) de sortie,
- détermination par comparaison du signal (S1) émis par le premier oscillateur (OSC1) avec la première référence de temps (REF) de la dérive en fréquence due à la température du signal (S1) émis par le premier oscillateur (OSC1),
- correction, en fonction de la valeur de ladite dérive, de la fréquence du signal (S1) émis par le premier oscillateur (OSC1) pour générer ledit signal de sortie formant une deuxième référence de temps (RTC).

**Claims**

**1.** Layout, the output signal of which is intended to form a time reference, including:

- a first oscillator (OSC1), including a resonator, of frequency $F_1$, of natural frequency $F_{10}$ and generating an output signal (S1),
- an oscillator circuit including a second oscillator (OSC2), including a resonator the frequency $F_2$ of which is different from that of the first oscillator (OSC1) and of natural frequency $F_{20}$,
- the second oscillator (OSC2) presenting a first order thermal coefficient $\alpha_2$ in a ratio $\lambda.F_{10}/F_{20}$ with the first order thermal coefficient $\alpha_1$ of said first oscillator (OSC1), $\lambda$ being a proportionality factor,
- means for generating, by frequency difference between the signal (S1) output by the first oscillator (OSC1) and the signal (S2) output by the oscillator circuit, a first temperature-stable time reference (REF),

**characterized**

- **in that** said resonators of said first and second oscillators, respectively, are silicon resonators,
- **in that** said oscillator circuit also includes a frequency divider dividing the frequency $F_2$ of the signal output by said second oscillator (OSC2) by said factor $\lambda$ and generating the output signal (S2) of said oscillator circuit,
- **in that** it comprises means (CTRL) for determining the frequency drift due to the temperature of the signal (S1) output by the first oscillator (OSC1) by comparing the signal (S1) output by the first oscillator (OSC1) with the first temperature-stable time reference (REF), and
- **in that** it comprises programmable correction means (DIV1) which, according to the value of said drift, divide the frequency of the signal (S1) output by the first oscillator (OSC1) and generate said output signal forming a second temperature-stable time reference (RTC).

2. Layout according to claim 1, **characterized in that** it includes:

- means (10, 11, 12, 13) for counting, during a counting phase and over a predetermined number of cycles (M) of the first time reference (REF), the number of pulses ($N_1$) generated by the first oscillator (OSC1), and
- means (33) for determining said frequency drift and controlling said programmable correction means, according to said number of pulses ($N_1$) counted and said number of cycles (M) of the first time reference (REF) during which counting was enabled.

3. Layout according to claim 2, **characterized in that** it includes means of selecting standby mode (MV) for intermittently setting the second oscillator (OSC2) to standby mode, and **in that** said counting phase runs during a phase of activity of the second oscillator (OSC2).

4. Layout according to claim 3, **characterized in that** said means of selecting standby mode (MV) include means for varying the time interval between two successive reactivations, according to the accuracy required for the second time reference (RTC) and/or to the number of pulses ($N_1$) counted for the first oscillator (OSC1) in at least one of the preceding counting phases.

5. Layout according to one of claims 1 to 4, **characterized in that** it includes means for generating temperature information from the number of pulses ($N_1$) generated by the first oscillator (OSC1) in the counting phase.

6. Layout according to one of claims 1 to 5, **characterized in that** it includes means for storing calibration information concerning the first temperature-stable time reference (REF).

7. Layout according to one of claims 1 to 6, **characterized in that** the correction means include a programmable frequency divider having a range of division factors with which to compensate the frequency drifts of the first oscillator (OSC1) due to the temperature and/or the absolute accuracy of the first oscillator (OSC1).

8. Time base including a layout according to one of claims 1 to 7.

9. Thermometer including a layout according to one of claims 1 to 7.

10. Timepiece including a layout according to one of claims 1 to 7.

11. Method of generating a signal intended to form a time reference including the following steps:

- generation of a first output signal (S1), of a first frequency $F_1$, by a first oscillator (OSC1), including a silicon resonator, of natural frequency $F_{10}$,
- generation of a second frequency $F_2$, different from the first frequency, by a second oscillator (OSC2), including a silicon resonator, of natural frequency $F_{20}$ and which presents a first order thermal coefficient $\alpha_2$ in a ratio $\lambda.F_{10}/F_{20}$ with the first order thermal coefficient $\alpha_1$ of said first oscillator (OSC1), $\lambda$ being a proportionality factor,
- division of the frequency $F_2$ of the signal output by said second oscillator (OSC2), by said factor $\lambda$, to generate a second output signal (S2),
- generation of a first temperature-stable time reference (REF) by frequency difference between said first signal (S1) output by the first oscillator (OSC1) and said second output signal (S2),
- determination, by comparison of the signal (S1) output by the first oscillator (OSC1) with the first time reference (REF), of the frequency drift due to the temperature of the signal (S1) output by the first oscillator (OSC1),

- correction, according to the value of said drift, of the frequency of the signal (S1) output by the first oscillator (OSC1) to generate said output signal forming a second time reference (RTC).

**Patentansprüche**

1. Architektur, deren Ausgangssignal dazu bestimmt ist, eine Zeitreferenz zu bilden, mit

   - einem ersten einen Resonator aufweisenden Oszillator (OSC1) einer Frequenz $F_1$, der eine Eigenfrequenz $F_{10}$ hat und ein Ausgangssignal (S1) erzeugt,
   - eine Oszillatorschaltung, die einen zweiten einen Resonator aufweisenden Oszillator (OSC2) einer Frequenz $F_2$, die sich von derjenigen des ersten Oszillators (OSC1) unterscheidet, und eine Eigenfrequenz $F_{20}$ enthält,
   - wobei der zweite Oszillator (OSC2) einen Wärmekoeffizienten erster Ordnung $\alpha_2$ in einem Verhältnis $\lambda.F_{10}/F_{20}$ zum Wärmekoeffizienten erster Ordnung $\alpha_1$ des ersten Oszillators (OSC1) hat, wobei $\lambda$ ein Proportionalitätsfaktor ist,
   - Mittel, um durch Frequenzdifferenz zwischen dem vom ersten Oszillator (OSC1) gesendeten Signal (S1) und dem von der Oszillatorschaltung gesendeten Signal (S2) eine erste temperaturstabile Zeitreferenz (REF) zu erzeugen,

   **dadurch gekennzeichnet,**

   - **dass** die Resonatoren des ersten bzw. zweiten Oszillators aus Silicium sind,
   - **dass** die Oszillatorschaltung außerdem einen Frequenzteiler aufweist, der die Frequenz $F_2$ des vom zweiten Oszillator (OSC2) gesendeten Signals durch den Faktor $\lambda$ dividiert und das Ausgangssignal (S2) der Oszillatorschaltung erzeugt,
   - **dass** sie Mittel (CTRL) aufweist, um die Frequenzdrift aufgrund der Temperatur des vom ersten Oszillator (OSC1) gesendeten Signals (S1) durch Vergleich des vom ersten Oszillator (OSC1) gesendeten Signals (S1) mit der ersten temperaturstabilen Zeitreferenz (REF) zu bestimmen, und
   - **dass** sie programmierbare Korrekturmittel (DIV1) aufweist, die in Abhängigkeit vom Wert der Drift die Frequenz des vom ersten Oszillator (OSC1) gesendeten Signals (S1) teilen und das Ausgangssignal erzeugen, das eine zweite temperaturstabile Zeitreferenz (RTC) bildet.

2. Architektur nach Anspruch 1, **dadurch gekennzeichnet, dass** sie aufweist:

   - Mittel (10, 11, 12, 13), um während einer Zählphase und während einer vorbestimmten Anzahl von Zyklen (M) der ersten Zeitreferenz (REF) die Anzahl von Impulsen (N1) zu zählen, die vom ersten Oszillator (OSC1) erzeugt werden, und
   - Mittel (33), um die Frequenzdrift zu bestimmen und die programmierbaren Korrekturmittel in Abhängigkeit von der abwärts gezählten Anzahl von Impulsen (N1) und der Anzahl von Zyklen (M) der ersten Zeitreferenz (REF) zu steuern, während der die Zählung autorisiert wurde.

3. Architektur nach Anspruch 2, **dadurch gekennzeichnet, dass** sie Mittel (MV) zum Versetzen in den Standby-Zustand aufweist, um den zweiten Oszillator (OSC2) intermittierend in den Standby-Zustand zu versetzen, und dass die Zählphase während einer Aktivitätsphase des zweiten Oszillators (OSC2) abläuft.

4. Architektur nach Anspruch 3, **dadurch gekennzeichnet, dass** die Mittel (MV) zum Versetzen in den Standby-Zustand Mittel aufweisen, die es ermöglichen, das Zeitintervall zwischen zwei aufeinander folgenden Aktivierungen in Abhängigkeit von der gewünschten Präzision für die zweite Zeitreferenz (RTC) und/oder der Anzahl von Impulsen (N1), die für den ersten Oszillator (OSC1) bei mindestens einer der vorhergehenden Zählphasen abwärts gezählt wurde, variieren zu lassen.

5. Architektur nach einem der Ansprüche 1 bis 4, **dadurch gekennzeichnet, dass** sie Mittel aufweist, um eine Temperaturinformation ausgehend von der Anzahl von Impulsen (N1) zu erzeugen, die vom ersten Oszillator (OSC1) in der Zählphase erzeugt werden.

6. Architektur nach einem der Ansprüche 1 bis 5, **dadurch gekennzeichnet, dass** sie Mittel aufweist, um Kalibrierungsinformationen der ersten temperaturstabilen Zeitreferenz (REF) zu speichern.

**7.** Architektur nach einem der Ansprüche 1 bis 6, **dadurch gekennzeichnet, dass** die Korrekturmittel einen programmierbaren Frequenzteiler aufweisen, der einen Teilungsverhältnisbereich besitzt, der es ermöglicht, die Frequenzdriften des ersten Oszillators (OSC1) aufgrund der Temperatur und/oder der absoluten Präzision des ersten Oszillators (OSC1) zu kompensieren.

**8.** Zeitbasis, die eine Architektur nach einem der Ansprüche 1 bis 7 aufweist.

**9.** Thermometer, das eine Architektur nach einem der Ansprüche 1 bis 7 aufweist.

**10.** Uhr, die eine Architektur nach einem der Ansprüche 1 bis 7 aufweist.

**11.** Verfahren zur Erzeugung eines Signals, das dazu bestimmt ist, eine Zeitreferenz zu bilden und die folgenden Schritte aufweist:

- Erzeugung eines ersten Ausgangssignals (S1) einer ersten Frequenz $F_1$ durch einen ersten einen Resonator aus Silicium aufweisenden Oszillator (OSC1) mit einer Eigenfrequenz $F_{10}$,
- Erzeugung einer zweiten Frequenz $F_2$, die sich von der ersten Frequenz unterscheidet, durch einen zweiten einen Resonator aus Silicium aufweisenden Oszillator (OSC2) mit einer Eigenfrequenz $F_{20}$ und mit einem Wärmekoeffizienten erster Ordnung $\alpha_2$ in einem Verhältnis $\lambda.F_{10}/F_{20}$ zum Wärmekoeffizienten erster Ordnung $\alpha_1$ des ersten Oszillators (OSC1), wobei $\lambda$ ein Proportionalitätsfaktor ist,
- Teilung der Frequenz $F_2$ des vom zweiten Oszillator (OSC2) gesendeten Signals durch den Faktor $\lambda$, um ein zweites Ausgangssignal (S2) zu erzeugen,
- Erzeugung einer ersten temperaturstabilen Zeitreferenz (REF) durch Frequenzdifferenz zwischen dem vom ersten Oszillator (OSC1) gesendeten ersten Signal (S1) und dem zweiten Ausgangssignal (S2),
- Bestimmung der Frequenzdrift aufgrund der Temperatur des vom ersten Oszillator (OSC1) gesendeten Signals (S1) durch Vergleich des vom ersten Oszillator (OSC1) gesendeten Signals (S1) mit der ersten Zeitreferenz (REF),
- Korrektur der Frequenz des vom ersten Oszillator (OSC1) gesendeten Signals (S1) in Abhängigkeit vom Wert der Drift, um das eine zweite Zeitreferenz (RTC) bildende Ausgangssignal zu erzeugen.

EP 1 634 373 B1

Fig. 1

Fig. 2

12

EP 1 634 373 B1

**Fig. 3**